# EUROPÄISCHE PATENTSCHRIFT

(11) **EP 0 849 981 B1**
(45) Veröffentlichungstag und Bekanntmachung des Hinweises auf die Patenterteilung: **14.02.2007**
(21) Anmeldenummer: 97250381.7
(22) Anmeldetag: 22.12.1997
(51) Int. Cl.: H05K 1/02, H01L 23/36, H05K 7/20

(54) **Beidseitig oder mehrschichtig kupferkaschierte Leiterplatte und Verfahren zu ihrer Herstellung**
Doublesided or multilayered copper laminated printed circuit board and method of making the same
Panneau à circuit à double face ou multicouche laminé d'un film en cuivre et méthode de fabrication associé

(30) Priorität: 20.12.1996 DE 19654606
(43) Veröffentlichungstag der Anmeldung: 24.06.1998
(73) Patentinhaber: PPC Electronic AG, 6330 Cham (CH)
(72) Erfinder: Richter, Dietrich, 14199 Berlin (DE); Berchtold, Dieter, 86932 Pürgen (DE); Lancki, Marian, 13587 Berlin (DE); Wissmeier, Hans-Georg, 81477 München (DE); Straub, Peter, 6317 Oberwill/Zug (CH); Diehm, Peter, 6332 Hagendorn/Cham (CH)
(74) Vertreter: Isler & Pedrazzini AG

(56) Entgegenhaltungen:
- EP-A- 0 712 153
- EP-A- 0 766 506
- DE-A- 4 107 312
- DE-A- 19 506 664
- US-A- 5 394 301
- ANONYMOUS: "Thermal Enhancement for a Printed Wiring Board, Thermal Finger Pad." IBM TECHNICAL DISCLOSURE BULLETIN, Bd. 33, Nr. 4, September 1990, NEW YORK, US, Seiten 403-404, XP002059227

## Beschreibung

Die Erfindung bezieht sich auf eine beidseitig oder mehrschichtig kupferkaschierte Leiterplatte mit einer Blei-Zinn-Schicht auf der Kupferkaschierung und mit einem plattenförmigen Kühlkörper.

Eine Leiterplatte dieser Art ist in der Druckschrift IPC Standard 1985, "Proposal Qualification and Performance Specification for Metal Core Boards" des Institute for Interconnecting and Packaging Electronic Circuits, Seiten 1 bis 5 dargestellt und beschrieben. Die bekannte Leiterplatte besteht im wesentlichen aus drei Teilen, nämlich einer inneren Metall-Kernplatte als Kühlkörper und zwei Kunststoffplatten, die beiderseits der Metall-Kernplatte angeordnet bzw. mit dieser verklebt sind. Auf ihren von der Metall-Kernplatte abgewandten Seiten sind die Kunststoffplatten kupferkaschiert und werden in üblicher Weise zum Aufbringen von elektronischen Bauelementen mit einer Blei-Zinn-Schicht versehen. Die Metall-Kernplatte bildet einen plattenförmigen Kühlkörper, durch den von den elektronischen Bauelementen erzeugte Wärme gut abgeführt werden kann. Die Wärmeableitung ist bei der bekannten Leiterplatte allerdings nicht optimal, weil der Wärmeübergang von den Kunststoffplatten zum plattenförmigen Kühlkörper durch die Klebschichten behindert ist.

Aus der Druckschrift DE-A1-41 07 312 ist eine Montageanordnung von Halbleiterbauelemente auf einer Leiterplatte bekannt, bei der die Leiterplatte mittels einer elektrisch isolierenden Zwischenschicht auf einem der Wärmeableitung dienenden metallischen Träger angeordnet ist. Die isolierende Zwischenschicht hemmt den Wärmeübergang zwischen der Leiterplatte und dem Träger.

Aus der EP-A2-0 712 153 ist es bekannt, zur Verbesserung der thermischen Ankopplung zwischen einem keramischen Träger eines Leistungshalbleiterbauelements und einer wärmeabführenden Grundplatte eine mechanisch entkoppelnde zusätzliche metallische Abschirmplatte vorzusehen. Obgleich Fehler durch unterschiedliche thermische Ausdehnung vermieden werden, behindern die zusätzlichen Schichten den Wärmeübergang.

Der Erfindung liegt die Aufgabe zugrunde, eine beidseitig oder mehrschichtig kupferkaschierte Leiterplatte vorzuschlagen, über die Wärme auch von stark wärmeerzeugenden elektronischen Bauelementen auf der Leiterplatte gut abgeführt werden kann.

Zur Lösung dieser Aufgabe ist bei einer Leiterplatte der eingangs angegebenen Art erfindungsgemäß der mit einer kupfernen Oberfläche und darauf aufgebrachter Silberschicht versehene Kühlkörper auf eine Seite der Leiterplatte aufgelötet. Diese Art der Anbringung des plattenförmigen Kühlkörpers an der Leiterplatte führt zu einem sehr guten thermischen Übergang zwischen der Leiterplatte und dem Kühlkörper, wodurch von elektronischen Bauelementen auf der Leiterplatte erzeugte Wärme sehr gut abgeleitet wird.

Bei der erfindungsgemäßen Leiterplatte kann der Kühlkörper unterschiedlich ausgebildet sein. Als vorteilhaft wird es angesehen, wenn der Kühlkörper eine Kupferplatte ist, weil sich bei einer derartigen Ausgestaltung die Herstellung der Leiterplatte insofern vereinfacht, weil vor dem Auflöten der Kupferplatte auf die Leiterplatte als zwischengeordneter Arbeitsgang nur noch das Aufbringen der Silberschicht erforderlich ist.

Es wird im Rahmen der Erfindung aber auch als vorteilhaft angesehen, wenn der Kühlkörper eine zumindest einseitig kupferkaschierte und mit einer Silberschicht versehene Kunststoffplatte mit Wärmeabführungsbohrungen ist. Die Herstellung einer derartigen Kunststoffplatte bereitet im Rahmen der Fertigung der erfindungsgemäßen Leiterplatte keine nennenswerten Schwierigkeiten, weil die Kunststoffplatte mit den Einrichtungen hergestellt werden kann, die in der Leiterplattenfertigung ohnehin zur Verfügung stehen. Als Werkstoff kommt für eine solche Kunststoffplatte ein Kunststoff in Frage, der sich vor allem durch eine hohe thermische Leitfähigkeit auszeichnet und einen Ausdehnungskoeffizienten aufweist, der etwa dem von Kupfer und Silber entspricht. Bei einer derartigen Werkstoffauswahl ist sichergestellt, daß die Ver-bindungsstelle zwischen der Kunststoffplatte und der Leiterplatte zuverlässig hält.

Um die Wärmeabführung bei Verwendung eines Kühlkörpers aus einer Kunststoffplatte zu fördern, ist diese vorteilhafterweise im Bereich ihrer Wärmeabführungsbohrungen mit Kupfer durchmetallisiert. Besonders gut ist die Wärmeabführung dann, wenn die Wärmeabführungsbohrungen mit thermisch leitfähiger Paste gefüllt sind.

Falls die Wärmeentwicklung der elektronischen Bauelemente auf der Leiterplatte besonders hoch und damit eine starke Wärmeabführung erforderlich ist, ist in die Kunststoffplatte vorteilhafterweise eine metallene Wärmeableitplatte eingepreßt. Durch die Wärmeableitplatte wird die Wärmeableitung bzw. Wärmeabstrahlung gefördert.

Die Erfindung bezieht sich ferner auf ein Verfahren zum Herstellen einer beidseitig kupferkaschierten Leiterplatte mit einer Blei-Zinn-Schicht auf der Kupferkaschierung und mit einem plattenförmigen Kühlkörper und sieht erfindungsgemäß vor, daß ein eine kupferne Oberfläche aufweisender Kühlkörper mit einer Silberschicht versehen wird, der Kühlkörper mit seiner die Silberschicht tragenden Seite auf die Leiterplatte aufgelegt wird und der Kühlkörper mit der Leiterplatte verpreßt wird, wobei an dem Kühlkörper eine beheizte Andruckplatte anliegt.

Ein wesentlicher Vorteil des erfindungsgemäßen Verfahrens besteht darin, daß durch die beheizte Andruckplatte eine derartige Erwärmung der Übergangsstelle zwischen der Leiterplatte und dem Kühlkörper erreicht wird, daß ein Auflöten des Kühlkörpers auf die eine Seite der Leiterplatte erfolgt. Durch das Verpressen erfolgt dabei zusätzlich eine innige Verbindung des Kühlkörpers mit der Leiterplatte auf deren einer Seite, so daß dort ein guter thermischer und auch elektrischer Übergang gewährleistet ist. Die Temperaturbeaufschlagung beim Verpressen ist dabei so gewählt, daß die Blei-Zinn-Schicht auf der von dem Kühlkörper abgewandten Seite der Leiterplatte nicht schmilzt. Dadurch ist erreicht, daß die Blei-Zinn-Schicht auf der von dem Kühlkörper abgewandten Seite ihre ursprüngliche Schmelztemperatur beibehält, während die Blei-Zinn-Schicht zwischen der Leiterplatte und dem Kühlkörper durch den Lötprozeß und das Verpressen einen höheren Schmelzpunkt erhalten hat. Damit ist die Möglichkeit gegeben, beim Verlöten von Bauelementen auf der von dem Kühlkörper abgewandten Seite nur die Blei-Zinn-Schicht auf dieser Seite der Leiterplatte aufzuschmelzen und die Bauelemente zu löten; die Verbindungsstelle zwischen der Leiterplatte und dem Kühlkörper wird durch das Löten der Bauelemente nicht beeinflußt.

Falls durch eine der beheizten Andruckplatte gegenüberliegende weitere Andruckplatte mit Raumtemperatur ein Schmelzen der Blei-Zinn-Schicht auf der von dem Hohlkörper abgewandten Seite beim Verpressen der Leiterplatte mit dem Kühlkörper nicht zu verhindern ist, wird gemäß einer weiteren Ausgestaltung des erfindungsgemäßen Verfahrens die von dem Kühlkörper abgewandte Seite der Leiterplatte beim Verpressen gekühlt.

Diese Kühlung kann in unterschiedlicher Weise vorgenommen werden; als vorteilhaft wird es angesehen, wenn eine der beheizten Andruckplatten gegenüberliegende weitere Andruckplatte während des Verpressens gekühlt wird.

Gegebenenfalls kann es aber auch ausreichend sein, wenn die Kühlung mittels eines beim Verpressen auf die von dem Kühlkörper abgewandte Seite der Leiterplatte aufgelegten Kühlbleches vorgenommen wird, das aus der Preßvorrichtung herausragt und damit die Kühlung bewirkt.

Zur Erläuterung der Erfindung ist in
Figur 1 in einer Art Sprengzeichnung eine Seitenansicht einer Leiterplatte und eines mit ihr zu verbindenden Kühlkörperd, in
Figur 2 in einer Seitenansicht die mit dem Kühlkörper verlötete Leiterplatte gemäß Figur 1, in
Figur 3 eine perspektivische Darstellung eines von einer Kunststoffplatte gebildeten Kühlkörpers, in
Figur 4 ein Schnitt durch eine Kunststoffplatte nach Figur 3 entlang der Linie IV-IV mit einer eingepreßten Wärmeableitplatte und in
Figur 5 schematisch in Form einer Art Sprengzeichnung eine Seitenansicht auf eine Preßvorrichtung zur Durchführung des erfindungsgemäßen Verfahrens mit darin untergebrachter Leiterplatte und Kühlkörper dargestellt.

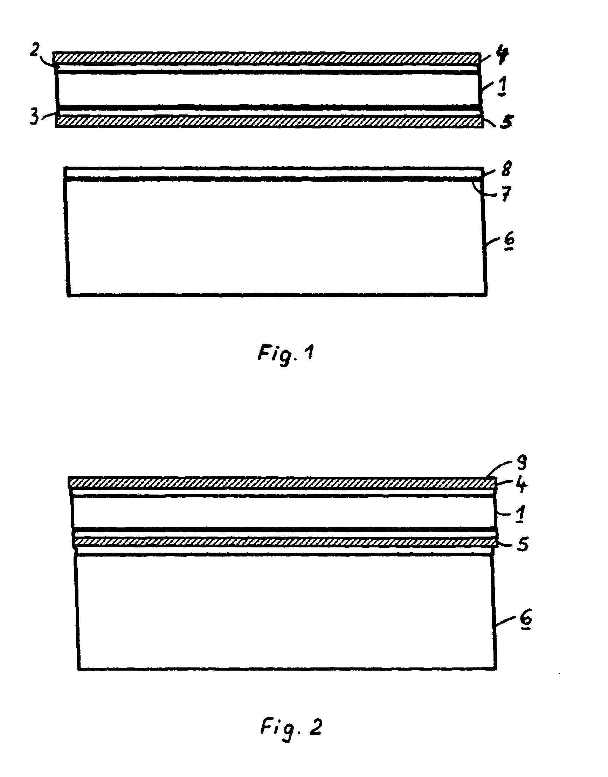

Die Figur 1 läßt eine Leiterplatte 1 erkennen, die beidseitig eine Kupferkaschierung 2 bzw. 3 aufweist. Auf jede Kupferkaschierung 2 bzw. 3 ist eine Blei-Zinn-Schicht 4 bzw. 5 aufgebracht.

Ferner zeigt die Figur 1 einen Kühlkörper 6, der von einer Kupferplatte gebildet ist. Die Kupferplatte 6 ist auf einer Seite 7 mit einer Silberschicht 8 versehen.

Wie unten näher erläutert ist, wird die Kupferplatte 6 mit der Leiterplatte 1 verlötet und verpreßt, so daß dann die Leiterplatte 1 mit der Kupferplatte 6 einen zusammenhängenden Verband bildet, wie er in der Figur 2 dargestellt ist. Durch die Blei-Zinn-Schicht 5 auf der Leiterplatte 1 erfolgt ein Verlöten mit der Kunststoffplatte 6, so daß von nicht dargestellten Bauelementen auf der in der Figur 2 oberen Seite der Leiterplatte 1 erzeugte Wärme sehr gut zu der Kupferplatte 6 übertragen und von dieser abgestrahlt werden kann.

Die Anordnung von Leiterplatte 1 und Kupferplatte 6, wie sie in Figur 2 dargestellt ist, läßt sich anschließend ohne weiteres in einer Weise mit elektronischen Bauelementen auf der Seite 9 versehen, wie dies in der Leiterplattenherstellung üblich ist. Durch das Verlöten der Leiterplatte 1 mit der Kupferplatte 6 hat nämlich die Blei-Zinn-Schicht 5 zwischen der Leiterplatte 1 und der Kupferplatte 6 einen höheren Schmelzpunkt erhalten als die Blei-Zinn-Schicht 4 auf der Seite 9 der Leiterplatte 1.

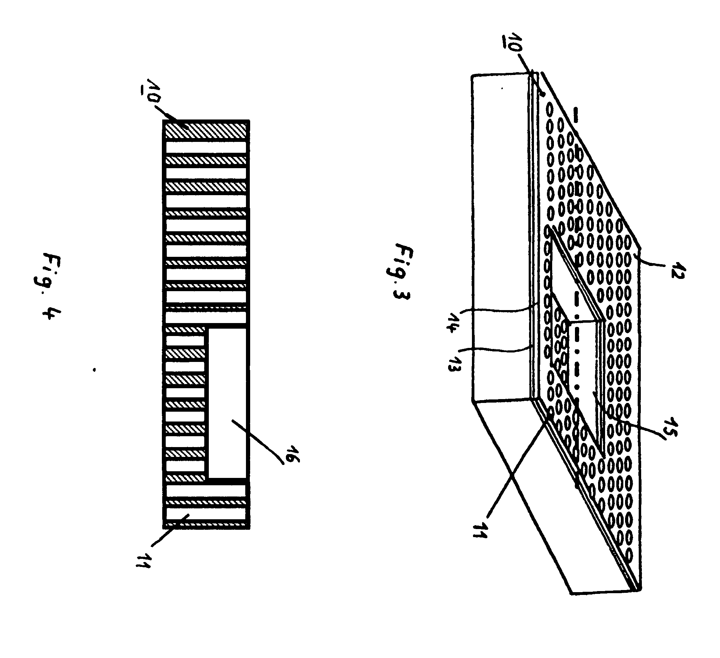

In Figur 3 ist ein Kühlkörper dargestellt, der von einer Kunststoffplatte 10 gebildet ist. Diese Kunststoffplatte 10 besteht aus einem Werkstoff mit einer hohen thermischen Leitfähigkeit und einem Temperaturausdehnungskoeffizienten, der etwa dem von Kupfer entspricht; ein derartiger Kunststoff wird von der Fa. Rogers, USA unter der Bezeichnung RO4000 angeboten; er ist in der Druckschrift Rogers High Frequency Circuit Materials RO 4000" der Firma Rogers Corporation, Chandler, AZ, USA im einzelnen beschrieben. Um der Kunststoffplatte 10 eine besonders hohe Wärmeableitfähigkeit zu verleihen, ist sie mit Wärmeabführungsbohrungen 11 versehen, die auch als sog. thermische Vias bezeichnet werden. Die Wärmeabführungsbohrungen sind - was in der Figur 3 der besseren Übersichtlichkeit halber nicht dargestellt ist - im Innern mit Kupfer durchmetallisiert. Um die Wärmeableitfähigkeit noch weiter zu erhöhen, können sie mit einer leitfähigen Paste gefüllt sein, die jedoch zweckmäßigerweise erst dann aufgebracht ist, nachdem die Kunststoffplatte 10 mit einer in der Figur 3 nicht dargestellten Leiterplatte entsprechend der Leiterplatte 1 nach den Figuren 1 und 2 verbunden ist.

Um die Kunststoffplatte 10 mit einer Leiterplatte durch Löten verbinden zu können, ist sie auf ihrer Oberfläche 12 verkupfert (Kupferkaschierung 13) und anschließend - vorzugsweise galvanisch - mit einer Silberschicht 14 versehen. Die Kunststoffplatte 10 ist damit so weit vorbereitet, wie die Kupferplatte 6 gemäß den Figuren 1 und 2.

Wie die Figur 3 ferner erkennen läßt, ist die Kunststoffplatte 10 mit einer rechteckförmigen Ausnehmung 15 versehen. In diese Ausnehmung 15 ist - wie Figur 4 zeigt - eine Wärmeableitplatte 16 eingepreßt. Diese Wärmeableitplatte 16 kann aus Kupfer oder aus Aluminium bestehen.

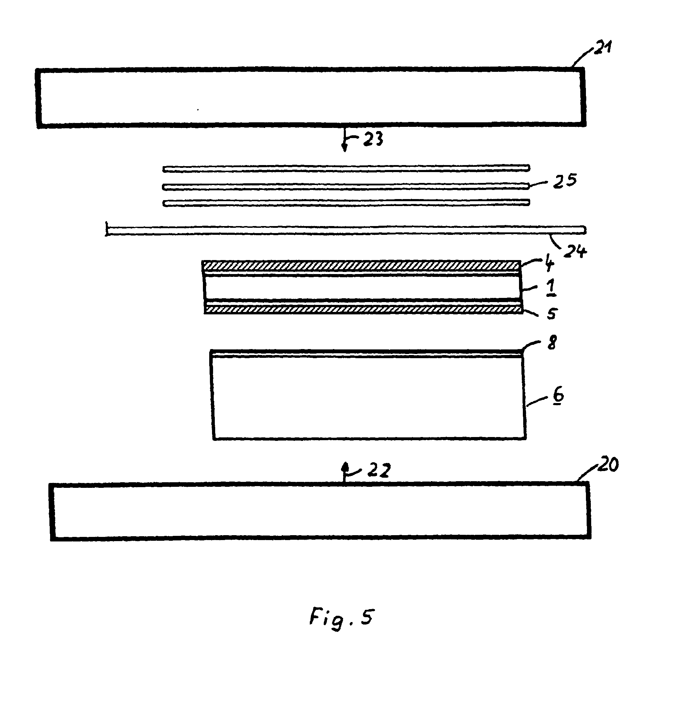

In Figur 5 ist eine zur Herstellung der Leiterplatte nach dem erfindungsgemäßen Verfahren geeignete Preßvorrichtung lediglich mit einer beheizten Andruckplatte 20 und einer dieser gegenüberliegenden weiteren Andruckplatte 21 dargestellt. Die Anordnung der beiden Andruckplatten 20 und 21 innerhalb der gesamten Preßvorrichtung ist nicht weiter gezeigt, weil sie im Zusammenhang mit der vorliegenden Erfindung von untergeordneter Bedeutung ist. So ist auch nicht dargestellt, in welcher Form die Andruckplatten 20 und 21 in Richtung der Pfeile 22 und 23 aufeinander zu bewegt werden. In der Figur 5 sind der besseren Übersichtlichkeit halber ferner die einzelnen zwischen den beiden Andruckplatten 20 und 21 tatsächlich eng aneinanderliegenden Komponenten beabstandet dargestellt.

Wie die Figur 5 weiter im einzelnen zeigt, ist beispielsweise eine Leiterplatte 1 gemäß den Figuren 1 und 2 und eine Kupferplatte 6 gemäß denselben Figuren zwischen den beiden Andruckplatten 20 und 21 derart angeordnet, daß die Kupferplatte 6 der Blei-Zinn-Schicht 5 mit ihrer Silberschicht 8 gegenüberliegt. Auf der von der Kupferplatte 6 abgewandten Seite 9 der Leiterplatte 1 liegt eine Kühlkonstruktion oder ein Kühlblech 24 auf, das aus dem Bereich der Andruckplatten 20 und 21 nach außen herausgeführt ist und mit dem eine Kühlung der Blei-Zinn-Schicht 4 der Leiterplatte 1 während des Pressens und verlötens erfolgt. Oberhalb des Kühlbleches 24 befindet sich ein Preßpolster 25 oder eine druckausgleichende Einlage, z. B. eine Federkonstruktion. Bei Verwendung einer Federkonstruktion kann die Kühlung auch gut mittels eines Luftstromes erfolgen.

Beim Herstellen der erfindungsgemäßen Leiterplatte werden die Andruckplatten 20 und 21 unter Zusammenpressen der zwischen ihnen befindlichen Teile mit der Leiterplatte 1 und der Kupferplatte 6 gegeneinandergeführt, wobei von der beheizten Andruckplatte 20 eine derartige Erwärmung der Kupferplatte 6 erfolgt, daß die Blei-Zinn-Schicht 5 aufschmilzt. Es wird dadurch die Leiterplatte 1 mit der Kupferplatte 6 verlötet. Durch das Kühlblech 24 ist dabei dafür gesorgt, daß die Blei-Zinn-Schicht 4 nicht aufschmilzt. Dadurch behält die Blei-Zinn-Schicht 4 ihren ursprünglichen Schmelzpunkt, während der Schmelzpunkt der Blei-Zinn-Schicht 5 durch das Verlöten erhöht ist.

Nach dem Verlöten der Leiterplatte 1 mit der Kupferplatte 6 können die Andruckplatten 20 und 21 auseinandergefahren werden, und es kann der Verbund aus der Leiterplatte 1 und der Kupferplatte 6 entnommen werden. Anschließend kann der Verbund in einer Weise mit elektronischen Bauelementen bestückt werden, wie es sonst bei der Leiterplattenfertigung üblich ist.

## Patentansprüche

1. Beidseitig oder mehrschichtig kupferkaschierte Leiterplatte (1) mit einer Blei-Zinn-Schicht (4, 5) auf der Kupferkaschierung (3, 4) und mit einem plattenförmigen Kühlkörper (6),
**dadurch gekennzeichnet, daß**
- der mit einer kupfernen Oberfläche und darauf aufgebrachter Silberschicht (8) versehene Kühlkörper (6) auf eine Seite der Leiterplatte (1) aufgelötet ist.

2. Leiterplatte nach Anspruch 1,
**dadurch gekennzeichnet, daß**
- der Kühlkörper eine Kupferplatte (6) ist.

3. Leiterplatte nach Anspruch 1,
**dadurch gekennzeichnet, daß**
- der Kühlkörper eine zumindest einseitig kupferkaschierte (Kupferkaschierung (13)) und mit einer Silberschicht (14) versehene Kunststoffplatte (10) mit Wärmeabführungsbohrungen (11) ist.

4. Leiterplatte nach Anspruch 3,
**dadurch gekennzeichnet, daß**
- die Wärmeabführungsbohrungen mit Kupfer durchmetallisiert sind.

5. Leiterplatte nach Anspruch 3 oder 4,
**dadurch gekennzeichnet, daß**
- die Wärmeabführungsbohrungen mit thermisch leitfähiger Paste gefüllt sind.

6. Leiterplatte nach einem der Ansprüche 3 bis 5,
**dadurch gekennzeichnet, daß**
- in die Kunststoffplatte (10) eine metallene Wärmeableitplatte (16) eingepreßt ist.

7. Verfahren zum Herstellen einer beidseitig kupferkaschierten Leiterplatte (1) mit einer Blei-Zinn-Schicht (4, 5) auf der Kupferkaschierung (2, 3) und mit einem plattenförmigen Kühlkörper (6),
**dadurch gekennzeichnet, daß**
- ein eine kupferne Oberfläche aufweisender Kühlkörper (6) mit einer Silberschicht (8) versehen wird,
- der Kühlkörper (6) mit seiner die Silberschicht (8) tragenden Seite auf die Leiterplatte (1) aufgelegt wird, und
- der Kühlkörper (6) mit der Leiterplatte (1) verpreßt wird, wobei an dem Kühlkörper (6) eine beheizte Andruckplatte (20) anliegt.

8. Verfahren nach Anspruch 7,
**dadurch gekennzeichnet, daß**
- die von dem Kühlkörper (6) abgewandte Seite (9) der Leiterplatte (1) beim Verpressen gekühlt wird.

9. Verfahren nach Anspruch 8,
**dadurch gekennzeichnet, daß**
- eine der beheizten Andruckplatte gegenüberliegende weitere Andruckplatte (21) während des Verpressens gekühlt wird.

10. Verfahren nach Anspruch 8,
**dadurch gekennzeichnet, daß**
- die Kühlung mittels eines beim Verpressen auf die von dem Kühlkörper (6) abgewandte Seite (9) der Leiterplatte (1) aufgelegten Kühlbleches (24) vorgenommen wird.

11. Verfahren nach Anspruch 8,
**dadurch gekennzeichnet, daß**
- die Kühlung mittels eines Luftstromes vorgenommen wird.

## Claims

1. Printed circuit board (1) which is copper-coated on both sides or in multilayer fashion, having a lead-tin layer (4, 5) on the copper coating (3, 4) and having a heat sink (6) in the form of a plate,
**characterized in that**
- the heat sink (6), which is provided with a copper surface and a silver layer (8) applied thereto, is soldered onto one side of the printed circuit board (1).

2. Printed circuit board according to Claim 1,
**characterized in that**
- the heat sink is a copper plate (6).

3. Printed circuit board according to Claim 1,
**characterized in that**
- the heat sink is a plastic plate (10) with heat-dissipating holes (11), which plastic plate is copper-coated at least on one side (copper coating (13)) and is provided with a silver layer (14).

4. Printed circuit board according to Claim 3,
**characterized in that**
- the heat-dissipating holes are plated-through with copper.

5. Printed circuit board according to Claim 3 or 4,
**characterized in that**
- the heat-dissipating holes are filled with thermally conductive paste.

6. Printed circuit board according to one of Claims 3 to 5,
**characterized in that**
- a metal heat-dissipating plate (16) is pressed into the plastic plate (10).

7. Method for the production of a printed circuit board (1) which is copper-coated on both sides, having a lead-tin layer (4, 5) on the copper coating (2, 3) and having a heat sink (6) in the form of a plate,
**characterized in that**
- a heat sink (6) having a copper surface is provided with a silver layer (8),
- the heat sink (6) is placed with its side that bears the silver layer (8) onto the printed circuit board (1), and
- the heat sink (6) is pressed together with the printed circuit board (1), a heated pressure plate (20) bearing on the heat sink (6).

8. Method according to Claim 7,
**characterized in that**
- that side (9) of the printed circuit board (1) which is remote from the heat sink (6) is cooled during the pressing process.

9. Method according to Claim 8,
**characterized in that**
- a further pressure plate (21) opposite the heated pressure plate is cooled during the pressing process.

10. Method according to Claim 8,
**characterized in that**
- the cooling is performed by means of a cold plate (24) which, during the pressing process, is placed onto that side (9) of the printed circuit board (1) which is remote from the heat sink (6).

11. Method according to Claim 8,
**characterized in that**
- the cooling is performed by means of an air stream.

## Revendications

1. Plaquette de circuit imprimé (1) plaquée de cuivre sur les deux faces ou en plusieurs couches, comprenant une couche de plomb-étain (4, 5) sur la couche de cuivre (2, 3) et un dissipateur thermique en forme de plaque (6),
**caractérisée en ce que**
le dissipateur thermique (6) pourvu d'une surface de cuivre et d'une couche d'argent (8) déposée sur celle-ci est brasé sur une face de la plaquette de circuit imprimé (1).

2. Plaquette de circuit imprimé selon la revendication 1,
**caractérisée en ce que**
le dissipateur thermique est une plaque de cuivre (6).

3. Plaquette de circuit imprimé selon la revendication 1,
**caractérisée en ce que**
le dissipateur thermique est une plaque de matière plastique (10) plaquée, au moins sur une face, d'une couche de cuivre (couche de cuivre (13)) et comprenant une couche d'argent (14), qui présente des trous de dissipation de chaleur (11).

4. Plaquette de circuit imprimé selon la revendication 3,
**caractérisée en ce que**
les trous de dissipation de chaleur sont métallisés au cuivre.

5. Plaquette de circuit imprimé selon la revendication 3 ou 4,
**caractérisée en ce que**
les trous de dissipation de chaleur sont remplis de pâte thermoconductrice.

6. Plaquette de circuit imprimé selon l'une quelconque des revendications 3 à 5,
**caractérisée en ce que**
une plaque de dissipation thermique métallique (16) est enfoncée dans la plaque de matière plastique (10).

7. Procédé de fabrication d'une plaquette de circuit imprimé (1) plaquée de cuivre sur les deux faces, comprenant une couche de plomb-étain (4, 5) sur la couche de cuivre (2, 3) et un dissipateur thermique en forme de plaque (6),
**caractérisé en ce que**
- un dissipateur thermique (6) présentant une surface de cuivre est pourvu d'une couche d'argent (8),
- le dissipateur thermique (6) est placé avec sa face portant la couche d'argent (8) sur la plaquette de circuit imprimé (1), et
- le dissipateur thermique (6) est comprimé avec la plaquette de circuit imprimé (1), une plaque de compression chauffée (20) étant appuyée contre le dissipateur thermique (6).

8. Procédé selon la revendication 7,
**caractérisé en ce que**
la face (9) de la plaquette de circuit imprimé (1) opposée au dissipateur thermique (6) est refroidie lors de la compression.

9. Procédé selon la revendication 8,
**caractérisé en ce que**
une autre plaque de compression (21) opposée à la plaque de compression chauffée est refroidie lors de la compression.

10. Procédé selon la revendication 8,
**caractérisé en ce que**
le refroidissement est réalisé au moyen d'une tôle de refroidissement (24) placée lors du refroidissement sur la face (9) de la plaquette de circuit imprimé (1) opposée au dissipateur thermique (6).

11. Procédé selon la revendication 8,
**caractérisé en ce que**
le refroidissement est réalisé au moyen d'un courant d'air.
